# EUROPÄISCHE PATENTSCHRIFT

(11) **EP 2 183 730 B1**
(45) Veröffentlichungstag und Bekanntmachung des Hinweises auf die Patenterteilung: **24.07.2013**
(21) Anmeldenummer: 08782829.9
(22) Anmeldetag: 26.08.2008
(51) Int. Cl.: H01L 31/02, G08B 13/14

(54) **VERFAHREN ZUR DIEBSTAHLERKENNUNG BEI EINER PHOTOVOLTAIKANLAGE UND WECHSELRICHTER FÜR EINE PHOTOVOLTAIKANLAGE**
METHOD FOR THEFT RECOGNITION ON A PHOTOVOLTAIC UNIT AND INVERTER FOR A PHOTOVOLTAIC UNIT
PROCÉDÉ DE DÉTECTION DE VOL ÉQUIPANT UNE INSTALLATION PHOTOVOLTAÏQUE, ET ONDULEUR POUR UNE INSTALLATION PHOTOVOLTAÏQUE

(30) Priorität: 29.08.2007 AT 13502007
(43) Veröffentlichungstag der Anmeldung: 12.05.2010
(73) Patentinhaber: Fronius International GmbH, 4643 Pettenbach (AT)
(72) Erfinder: MÜHLBERGER, Thomas, A-4614 Marchtrenk (AT); PRÖTSCH, Roland, A-4661 Roitham (AT)
(74) Vertreter: Sonn & Partner Patentanwälte
(86) Internationale Anmeldenummer: PCT/AT2008/000301
(87) Internationale Veröffentlichungsnummer: WO 2009/026602

(56) Entgegenhaltungen:
- EP-A1- 0 584 540
- WO-A-2007/048421
- WO-A-2008/043814
- WO-A-2008/046370
- DE-A1- 10 136 147
- GB-A- 2 286 475
- US-A- 4 121 201
- US-A1- 2002 063 625

## Beschreibung

Die Erfindung betrifft ein Verfahren zur Erkennung des Diebstahls zumindest eines Solarmoduls einer Photovoltaikanlage, nach dem Oberbegriff des Anspruchs 1.

Ebenso betrifft die Erfindung einen Wechselrichter nach dem Oberbegriff des Anspruchs 9.

Photovoltaikanlagen dienen zur Umwandlung der Strahlungsenergie der Sonne in elektrische Energie. Dazu sind Solarmodule, welche eine Gleichspannung produzierten und Wechselrichter, welche die Gleichspannung in eine Wechselspannung umwandeln, erforderlich. Die erzeugte Wechselspannung kann in das öffentliche Stromnetz oder an direkt angeschlossene Verbraucher angelegt werden.

Photovoltaikanlagen mit hoher Leistung und entsprechend großer Anzahl an Solarmodulen werden häufig im freien Gelände montiert. Hierbei sind die Komponenten der Photovoltaikanlage der Gefahr eines Diebstahls bzw. einer gewaltsamen Entfernung ausgesetzt. Insbesondere sind davon die teuren Solarmodule betroffen.

Es sind zwar Sicherheitsvorrichtungen, wie Umzäunungen, Video-überwachungen, Bewegungsmelder oder dgl. bekannt, erzielen aber oft nicht den gewünschten Effekt. Weiters sind derartige Maßnahmen relativ aufwändig und beispielsweise durch Tiere störanfällig.

Andere Vorrichtungen verwenden mechanische Sicherungen, wie Schlösser, Sensoren oder dgl., welche an den Solarmodulen befestigt werden. Hierbei ist der zusätzliche Montageaufwand, beispielsweise durch Verlegung zusätzlicher Leitungen, nachteilig.

Beispielsweise beschreibt die WO 2007/048421 A2 einen Schaltkreis für eine Photovoltaikanlage, mit dem Fehlfunktionen und auch ein Diebstahl der Solarmodule erkannt werden können.

Die DE 101 61 480 A1 zeigt ein Verfahren und eine Einrichtung zur Überwachung von Solarmodulen, wobei charakteristische Messgrößen auf sprunghafte Änderungen überwacht werden.

Die US 2002/0063625 A1 beschreibt eine Photovoltaikanlage, welche mit einer Diebstahlsicherung ausgestattet ist, mit der überprüft wird, ob die Solarmodule und der Inverter angeschlossen sind. Während der Nachtstunden, wenn die Solarzelle keine Spannung erzeugt, wird die Verbindung über ein entsprechendes eingespeistes Signal überprüft.

Die DE 94 11 783 U1 beschreibt einen Diebstahlschutz für photovoltaische Solargeneratoren, wobei im Falle der Entfernung einer Solarzelle die Spannung stark ansteigt, wodurch eine Alarmauslösung erfolgt und der Diebstahl detektiert werden kann.

Schließlich zeigt die JP 2000-164906 A eine Vorrichtung zur Erkennung eines Diebstahls von Solarmodulen einer Photovoltaikanlage, wobei an die Solarmodule ein Prüfstrom angelegt wird, dessen Unterschreitung im Falle eines Diebstahls erkannt wird.

Die Aufgabe der vorliegenden Erfindung besteht in der Schaffung eines oben genannten Verfahrens und eines oben genannten Wechselrichters, durch welche eine Photovoltaikanlage wirkungsvoll gegen einen Diebstahl der Solarmodule geschützt werden kann.

Die Aufgabe der Erfindung wird in verfahrensmäßiger Hinsicht durch die Merkmale des Anspruchs 1 gelöst.

Durch das erfindungsgemäße Verfahren kann eine Entfernung eines Solarmoduls wirkungsvoll erkannt werden. Der Aufwand ist relativ gering.

Durch den Einsatz von elektrischen Wechselsspannungssignalen, welche sich in Form und Amplitude unterscheiden, kann für den jeweiligen Typ des Solarmoduls ein optimales elektrisches Signal für die Diebstahlerkennung ausgewählt werden.

Die Erzeugung des elektrischen Wechselspannungssignals erfolgt vorzugsweise im Wechselrichter der Photovoltaikanlage, sodass keine zusätzlichen Komponenten montiert werden müssen. Auch ist es von Vorteil, dass die Diebstahlerkennung für einen Dieb nicht sichtbar ist.

Vorteilhafterweise wird das elektrische Wechselspannungssignal automatisch erzeugt und angelegt, wenn von zumindest einem Wechselrichter kein Wechselstrom erzeugt wird. Somit wird das Diebstahlerkennungsverfahren automatisch bei Dämmerung bzw. während der Nachtstunden, in welchen die Solarmodule keine Spannung liefert, automatisch aktiviert.

Um den Einbruch der Dämmerung bzw. der Nachtstunden zu erkennen, wird die Spannung der Solarmodule überwacht. Dadurch kann auch wieder automatisch der Tagesanbruch erkannt werden und die Diebstahlerkennung vorzugsweise automatisch abgeschaltet werden.

Die Solarmodule werden mit einer Umschaltvorrichtung von dem zumindest einen Wechselrichter getrennt, wenn eine definierte Spannung der Solarmodule gemessen wird. Dadurch kann erreicht werden, dass die Solarmodule während der Nachtstunden vom Wechselrichter oder den Wechselrichtern getrennt und mit der Diebstahlerkennungsvorrichtung verbunden wird.

Das elektrische Wechselspannungssignal wird von einer vorzugsweise in der Umschaltvorrichtung integrierten Signaleinheit erzeugt, wobei diese von einer Steuervorrichtung eines Wechselrichters aktiviert wird. Dadurch ist die Umschaltvorrichtung unabhängig vom Wechselrichter und bzw. kann auf diesen abgestimmt und auch nachträglich eingebaut werden. Der Normalbetrieb des Wechselrichters wird durch die Umschaltvorrichtung nicht beeinflusst.

Zur Aktivierung der Umschaltvorrichtung und der Diebstahlerkennung wird von der Steuervorrichtung des Wechselrichters vorzugsweise ein Startsignal an die Umschaltvorrichtung übermittelt.

Vorzugsweise wird die Verbindung zumindest einer Anschlussleitung mit dem zumindest einen Wechselrichter durch zumindest einen Umschalter unterbrochen und zumindest eine der Anschlussleitungen durch zumindest einen Umschalter mit der Signaleinheit verbunden, wenn die Umschaltvorrichtung aktiviert wird. Durch die Umschaltung kann für die Diebstahlerkennung ein eigener Stromkreis gebildet werden, wodurch dieser unabhängig von der eigentlichen Wechselrichterfunktion betrieben werden kann. Ebenso ist durch die Umschaltung die Elektronik des zumindest einen Wechselrichters vom elektrischen Signal zur Diebstahlerkennung getrennt und somit geschützt.

Wenn der Typ der Solarmodule nicht bekannt ist, können unterschiedliche elektrische Wechselspannungssignale hintereinander an das zumindest eine Solarmodul gesendet werden und jenes elektrische Signal als Referenzsignal ausgewählt werden, welches bei vorhandenen Solarmodulen ein verwertbares empfangenes Signal hervorruft. Dadurch kann das optimale Signal für den jeweiligen Typ des Solarmoduls automatisch ermittelt werden. Demnach erfolgt eine Kalibrierung des elektrischen Signals auf den Typ der eingesetzten Solarmodule. Dadurch kann auch ein Tausch der Solarmodule auf einen anderen Typ automatisch erkannt werden.

Alternativ dazu können mit dem Startsignal zur Aktivierung der Diebstahlerkennung Informationen über den Typ der Solarmodule übermittelt und in Abhängigkeit des Typs der Solarmodule bzw. der Informationen ein entsprechendes elektrisches Signal von der Signaleinheit erzeugt werden. Auf diese Weise kann das elektrische Signal aufgrund der übermittelten Informationen über den Typ der Solarmodule von der Signaleinheit generiert und ausgesendet werden.

Das elektrische Wechselspannungssignal wird zwischen den Anschlussleitungen oder ein Hochfrequenzsignal zwischen den Anschlussleitungen oder zwischen einer der Anschlussleitungen und "Erde" angelegt.

Wenn das elektrische Wechselspannungssignal in vorzugsweise periodischen Zeitabständen ausgesendet wird, kann der Energieverbrauch sehr niedrig gehalten und trotzdem ein Diebstahl eines Solarmoduls im Wesentlichen sofort erkannt werden.

Vorteilhafterweise wird ein Diebstahl eines Solarmoduls aufgrund einer sprunghaften Änderung des empfangenen Signals erkannt und ein Alarmsignal erzeugt.

Dabei kann das Alarmsignal an eine Datenkommunikationseinheit übermittelt werden und beispielsweise von dieser Datenkommunikationseinheit eine Nachricht an einen definierten Empfänger auf eine definierte Übertragungsmethode übermittelt werden. Insbesondere kann ein im Wechselrichter allenfalls vorhandenes Kommunikationssystem verwendet werden, wodurch sich der Aufwand bei einem nachträglichen Einbau der Komponenten der Diebstahlerkennung reduziert.

Die Aufgabe der Erfindung wird auch durch einen oben genannten Wechselrichter mit den Merkmalen gemäß dem Anspruch 12 gelöst.

Vorteile dazu und zu den abhängigen Ansprüchen können aus den bereits angeführten Vorteilen entnommen werden. Ebenso können weitere Vorteile der Erfindung aus der nachfolgenden Beschreibung entnommen werden.

Die vorliegende Erfindung wird anhand der beigefügten, schemati schen Zeichnungen näher erläutert.

Darin zeigen Fig. 1 eine schematische Übersichtsdarstellung eines Wechselrichters einer Photovoltaikanlage; Fig. 2 einen detaillierten schematischen Aufbau einer Photovoltaikanlage mit der erfindungsgemäßen Diebstahlerkennung im Normalbetrieb; Fig. 3 einen detaillierten schematischen Aufbau einer Photovoltaikanlage mit der erfindungsgemäßen Diebstahlerkennung im Überwachungsbetrieb; und Fig. 4 einen detaillierten schematischen Aufbau einer Photovoltaikanlage mit der erfindungsgemäßen Diebstahlerkennung im Überwachungsbetrieb bei einem Diebstahl eines Solarmoduls.

Einführend wird festgehalten, dass gleiche Teile des Ausführungsbeispiels mit gleichen Bezugszeichen versehen werden.

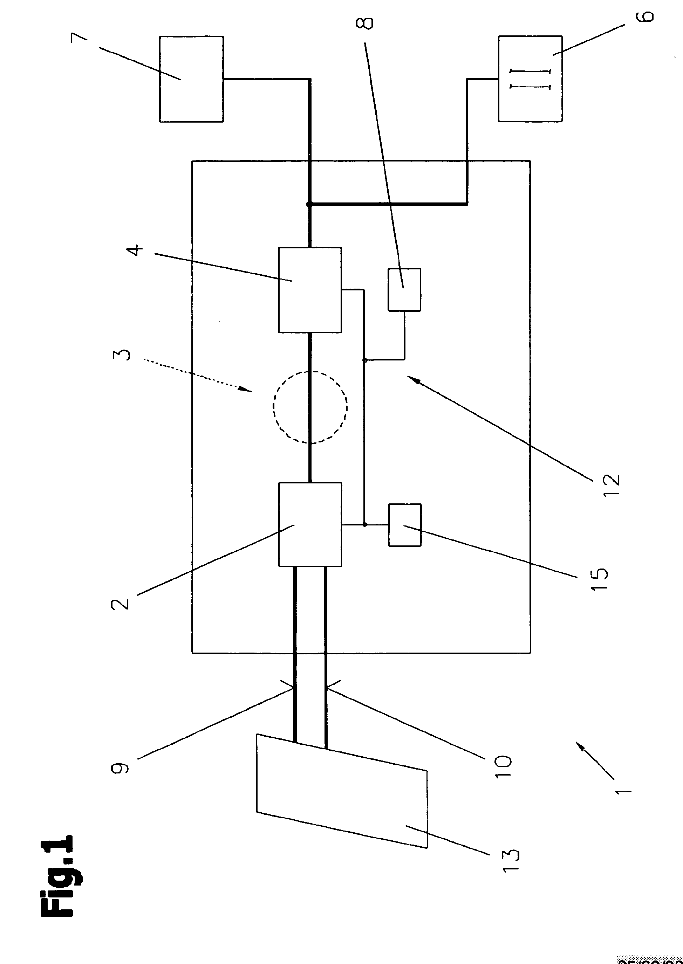

In Fig. 1 ist ein Aufbau eines Wechselrichters 1, im Detail eines HF-Wechselrichters, dargestellt. Da die einzelnen Komponenten bzw. Baugruppen und Funktionen von Wechselrichtern 1 bereits aus dem Stand der Technik bekannt sind, wird auf diese nachstehend nicht im Detail eingegangen.

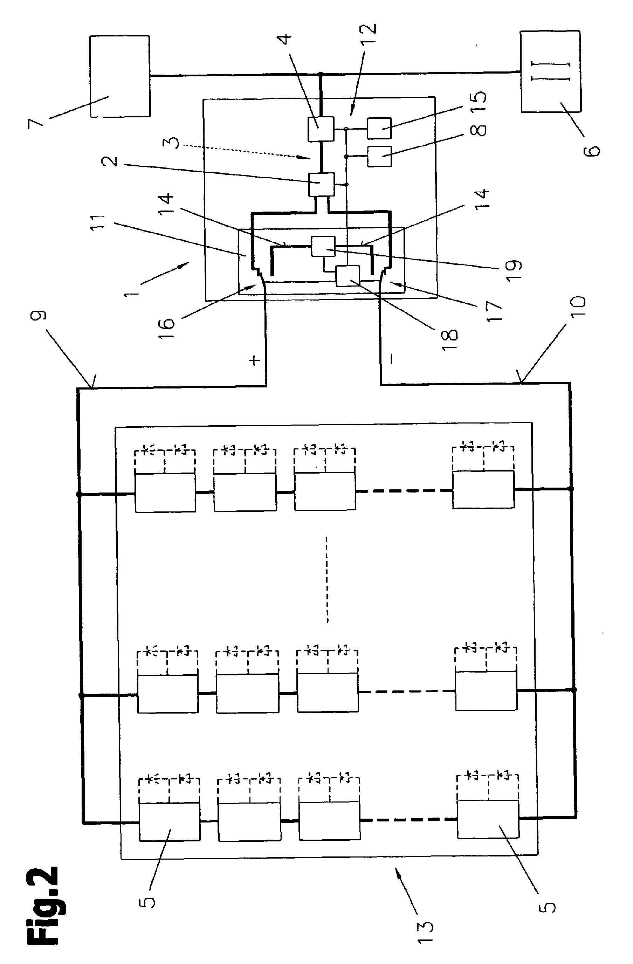

Der Wechselrichter 1 weist zumindest einen Eingangs-DC-DC-Wandler 2, einen Zwischenkreis 3 und einen Ausgangs-DC-AC-Wandler 4 auf. Am Eingangs-DC-DC-Wandler 2 ist eine Energiequelle 13 bzw. ein Energieerzeuger angeschlossen, die bevorzugt aus einem oder mehreren parallel und/oder seriell zueinander geschalteten Solarmodulen 5 (s. Fig. 2 - 4) gebildet wird. Der Wechselrichter 1 und die Solarmodule 5 werden auch als Photovoltaikanlage bzw. als PV-Anlage bezeichnet. Der Ausgang des Wechselrichters 1 bzw. der Ausgangs-DC-AC-Wandler 4 kann mit einem Versorgungsnetz 6, wie ein öffentliches oder privates Wechselspannungsnetz oder ein Mehr-Phasennetz, und/oder mit zumindest einem elektrischen Verbraucher 7, welcher eine Last darstellt, verbunden sein. Beispielsweise wird ein Verbraucher 7 durch einen Motor, Kühlschrank, Funkgerät usw. gebildet. Ebenso kann der Verbraucher 7 auch eine Hausversorgung darstellen. Die einzelnen Komponenten des Wechselrichters 1, wie der Eingangs-DC-DC-Wandler 2 usw., können über einen Datenbus 12 mit einer Steuervorrichtung 8 verbunden sein.

Bevorzugt dient ein derartiger Wechselrichter 1 als sogenannter netzgekoppelter Wechselrichter 1, dessen Energiemanagement daraufhin optimiert ist, möglichst viel Energie in das Versorgungsnetz 6 einzuspeisen. Wie aus dem Stand der Technik bekannt, werden die Verbraucher 7 über das Versorgungsnetz 6 versorgt. Selbstverständlich können auch mehrere parallel geschaltete Wechselrichter 1 eingesetzt werden. Dadurch kann mehr Energie zum Betrieb der Verbraucher 7 bereitgestellt werden.

Die Steuervorrichtung 8 bzw. der Regler des Wechselrichters 1 ist beispielsweise durch einen Mikroprozessor, Mikrocontroller oder Rechner gebildet. Über die Steuervorrichtung 8 kann eine entsprechende Steuerung der einzelnen Komponenten des Wechselrichters 1 wie dem Eingangs-DC-DC-Wandler 2 oder dem Ausgangs-DC-AC-Wandler 4, insbesondere der darin angeordneten Schaltelemente, vorgenommen werden. In der Steuervorrichtung 8 sind hierzu die einzelnen Regel- bzw. Steuerabläufe durch entsprechende Software-Programme und/oder Daten bzw. Kennlinien gespeichert.

Die Energiequelle 13 ist über zwei Anschlussleitungen 9, 10 mit dem Wechselrichter 1 verbunden und liefert eine entsprechende Gleichspannung.

Erfindungsgemäß werden diese zwei Anschlussleitungen 9, 10 dazu herangezogen, ein elektrisches Signal durch die Energiequelle 13 bzw. Solarmodule 5 zu senden. Da die am Wechselrichter 1 angeschlossene Energiequelle 13 bzw. Solarmodule 5 einen elektrischen Stromkreis bilden, wird das vom Wechselrichter 1 ausgesandte Signal wieder empfangen. Somit kann über das vom Wechselrichter 1 ausgesandte Signal beurteilt werden, ob die Energiequelle 13 bzw. ein Solarmodul 5 entfernt bzw. gestohlen wurde.

Eine derartige Diebstahlerkennung wird nur dann durchgeführt, wenn die Solarmodule 5 keine ausreichend hohe Gleichspannung liefern, welche der Wechselrichter 1 entsprechend in eine netzkonforme Wechselspannung umwandeln könnte. Dies ist der Fall, wenn der Wechselrichter 1 keinen Wechselstrom mehr in das Versorgungsnetz 6 liefert. Somit startet bzw. aktiviert der Wechselrichter 1 die Diebstahlerkennung in den Nachtstunden bzw. bei Dämmerung.

Das erfindungsgemäße Verfahren zur Erkennung des Diebstahls eines Solarmoduls 5 mit dem erfindungsgemäßen Wechselrichter 1 ist in den folgenden Fig. 2 bis 4 dargestellt.

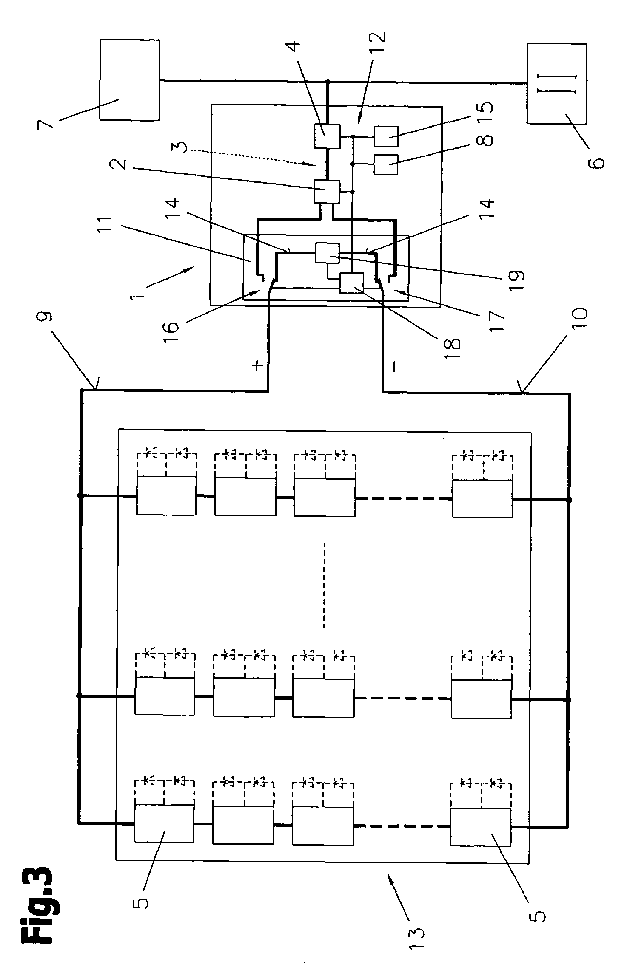

Für die Diebstahlerkennung ist im Wechselrichter 1 eine Umschaltvorrichtung 11 vorgesehen. Über die Umschaltvorrichtung 11 werden im Normalbetrieb des Wechselrichters 1, wenn dieser Energie ins Versorgungsnetz 6 einspeist, die Anschlussleitungen 9, 10 mit dem DC-DC-Wandler 2 verbunden, wie in Fig. 2 dargestellt. Sinkt die Spannung der Solarmodule 5, wie es bei Einbruch der Nachtstunden der Fall ist, kann der Wechselrichter 1 keine Energie mehr in das Versorgungsnetz 6 einspeisen. Bevorzugt in diesem Fall wird die erfindungsgemäße Diebstahlerkennung aktiviert, indem die Umschaltvorrichtung 11 den Wechselrichter 1 von den Solarmodulen 5 trennt, wie in Fig. 3 dargestellt. Hierzu werden die Anschlussleitungen 9, 10 beispielsweise über zwei Umschalter 16, 17 vom Eingangs-DC-DC-Wandler 2 des Wechselrichters 1 getrennt. Damit wird die Verbindung zwischen den Solarmodulen 5 und dem Wechselrichter 1 unterbrochen und insbesondere der Eingangskondensator des Wechselrichters 1 abgeklemmt, sodass dieser durch das elektrische Signal zur Diebstahlerkennung nicht zerstört werden kann. Über die Umschaltvorrichtung 11 bzw. die Umschalter 16, 17 werden nunmehr die Anschlussleitungen 9, 10 für die Energiequelle 13 bzw. die Solarmodule 5 über Verbindungsleitungen 14 mit einer Signaleinheit 19 verbunden wie dies in Fig. 3 dargestellt ist. Bevorzugt wird diese Unterbrechung über ein Startsignal, welches beispielsweise die Steuervorrichtung 8 des Wechselrichter 1 über den Datenbus 12 an eine Steuereinheit 18 der Umschaltvorrichtung 11 übermittelt, ausgelöst. Daraufhin veranlasst die Steuereinheit 18 die Aktivierung der Umschalter 16, 17.

Selbstverständlich kann die Umschaltvorrichtung 11 auch nur einen Umschalter enthalten, wodurch lediglich die Spannungsverluste eines Umschalters berücksichtigt werden müssen. Beispielsweise können Halbleiter, Relais oder ähnliche Bauteile als Umschalter 16, 17 eingesetzt werden.

Sind an den Anschlussleitungen 9, 10 beispielsweise zwei Wechselrichter 1 parallel geschaltet, werden beide Wechselrichter 1 zur Diebstahlerkennung durch die jeweils integrierte Umschaltvorrichtung 11 von den Solarmodulen 5 getrennt. Bevorzugt sind die Wechselrichter 1 mit einem Datenbus 12 verbunden, so dass die Trennung der Wechselrichter 1 im Wesentlichen gleichzeitig erfolgt. Ebenso werden bevorzugt über den Datenbus 12 Informationen ausgetauscht, zu welchem Zeitpunkt welcher Wechselrichter 1 das elektrische Signal zur Diebstahlerkennung sendet bzw. welcher von den Wechselrichtern 1 diese Funktion übernimmt. Somit ist gewährleistet, dass stets nur ein elektrisches Signal zur Diebstahlerkennung ausgesendet wird und daher keinen Störungen ausgesetzt ist.

Gemäß Fig. 3 wurde der Wechselrichter 1 von den Solarmodulen 5 getrennt, sodass das erfindungsgemäße Verfahren zur Diebstahlerkennung durchgeführt werden kann. Zu diesem Zweck wird ein in der Signaleinheit 19 erzeugtes elektrisches Signal über die Verbindungsleitungen 14 und die Anschlussleitungen 9, 10 in die Solarmodule 5 gesendet, um das Vorhandensein aller Solarmodule 5 zu überprüfen. Die Signaleinheit 19 kann in der Steuereinheit 18 der Umschaltvorrichtung 11 integriert oder mit dieser verbunden sein und beispielsweise durch einen Signalgenerator gebildet sein.

Die Signaleinheit 19 kann bevorzugt unterschiedliche elektrische Signale generieren, welche sich hauptsächlich in ihrer Signalform und der Amplitude unterscheiden. Somit ist die vom elektrischen Signal abhängige Diebstahlerkennung nicht auf bestimmte Typen von Solarmodulen 5 beschränkt. Beispielsweise können für verschiedene Typen von Solarmodulen 5 entsprechende Daten in einem Speicher der Steuereinheit 18 hinterlegt sein, aus denen die Signaleinheit 19 ein entsprechend geeignetes elektrisches Signal generiert. Damit nun die Signaleinheit 19 das an die verwendeten Solarmodule 5 angepasste elektrische Signal generieren kann, muss der Signaleinheit 19 der Typ der Solarmodule 5 bekannt sein. Dies kann nun anhand mehrerer Möglichkeiten festgestellt werden.

Zum einen kann bei der Inbetriebnahme der PV-Anlage der Typ der Solarmodule 5 im Wechselrichter 1 bzw. in der Steuervorrichtung 8 oder in der Umschaltvorrichtung 11 bzw. in der Steuereinheit 18 eingestellt werden. Aus dieser Einstellung generiert die Signaleinheit 19 anhand der hinterlegten Daten ein entsprechendes elektrisches Signal zur Durchführung der Diebstahlerkennung.

Ist bzw. wurde der Typ der Solarmodule 5 nicht eingestellt, so werden bevorzugt alle anhand der hinterlegten Daten generierbaren Signalformen hintereinander generiert und über die Anschlussleitungen 9, 10 durch die Solarmodule 5 gesendet. Jene Signalform, welche von der Signaleinheit 19 wieder korrekt bzw. verwertbar empfangen wird, wird dann für die Diebstahlerkennung verwendet. Entsprechende Kriterien für eine korrekt empfangene Signalform sind bevorzugt in einem Speicher hinterlegt.

Bevorzugt werden nun zur Diebstahlerkennung die im Folgenden beschriebenen Signalformen von der Signaleinheit 19 generiert, welche entsprechend auf den Typ der Solarmodule 5 abgestimmt sind. Die Signalform kann durch ein Wechselspannungssignal mit unterschiedlichen Amplituden gebildet werden.

Auch kann als Signalform ein Wechselspannungssignal mit besimmter Frequenz (insbesondere Hochfrequenz) und konstanter Amplitude verwendet werden. Das erzeugte Signal wird über eine Verbindungsleitung 14, die Sendeleitung und die entsprechende Anschlussleitung 9, 10 in die Solarmodule 5 übertragen und über die andere Anschlussleitung 10, 9 und die als Empfangsleitung dienende andere Verbindungsleitung 14 wieder empfangen. Diese Signalform wird bevorzugt für Solarmodule 5 verwendet, welche keine Dioden aufweisen und somit einen Stromfluss in beide Richtungen ermöglichen. Welche Richtung als Stromfluss zur Diebstahlerkennung verwendet wird, entscheidet die Umschaltvorrichtung 11 aufgrund der empfangenen Signalform, sodass ein Diebstahl auch korrekt erkannt wird. Somit kann wiederum der Strom durch die Solarmodule 5 fließen und von der Umschaltvorrichtung 11 bzw. der Signaleinheit 19 gemessen bzw. ausgewertet werden.

Ebenso kann ein solches Wechselspannungssignal zwischen einer der Anschlussleitungen 9, 10 und "Erde" angelegt werden. Demnach wird ein Wechselspannungssignal mit einer entsprechenden Amplitude, beispielsweise 20 Volt, an einer der Anschlussleitungen 9, 10 angelegt, sodass ein Teil dieser Wechselspannung zwischen einer geerdeten Halterung der Solarmodule 5 und "Erde" anliegt. Die Halterung und die Solarmodule 5 stellen eine Kapazität dar, sodass der Teil der Wechselspannung bzw. der daraus resultierende Strom als kapazitiver Ableitstrom bezeichnet wird. Dieser kapazitive Ableitstrom kann zwischen einer der Anschlussleitungen 9, 10 und "Erde" der Umschaltvorrichtung 11 gemessen werden, wobei dazu die Umschaltvorrichtung 11 geerdet sein muss. Bei einer Änderung dieses kapazitiven Ableitstroms kann ein Diebstahl festgestellt werden.

Da die Form des empfangenen Signals durch die Kapazität verändert wird, kann ein Diebstahl der Solarmodule 5 auch über einen Unterschied zwischen der Form des empfangenen und des gesendeten Signals erkannt werden. In diesem Fall wir das Wechselspannungssignal zwischen den Anschlussleitungen 9, 10 angelegt.

Im Fall von parallel und in Serie angeordneten Solarmodulen 5 wird sich das elektrische Signal im Wesentlichen gleichmäßig auf die parallel geschalteten Stränge aufteilen. Die Umschaltvorrichtung 11 bzw. die Signaleinheit 19 empfängt die Summe der Ströme aller Stränge.

Nachdem die Signalform für die Diebstahlerkennung entsprechend dem Typ der Solarmodule 5 festgelegt wurde, wird diese Signalform und die Form des normalerweise (d.h. bei Vorhandensein aller Solarmodule 5) empfangenen Signals gespeichert und eine Art Kalibrierung durchgeführt. Dabei dienen die gespeicherten Signalformen zumindest für die bevorstehende Nacht als Referenzwerte bzw. Vergleichswerte, sodass bei einer Abweichung der Form der empfangenen Signale vom Referenzwert ein Diebstahl zuverlässig erkannt wird.

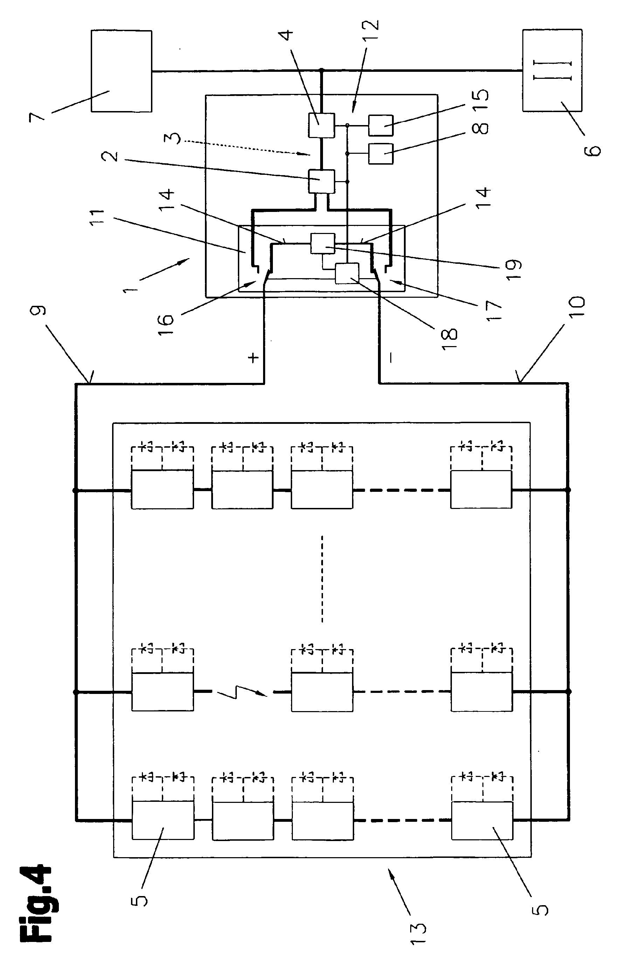

Eine Änderung bzw. Abweichung der empfangenen Signalform von der gesendeten Signalform wird im Wesentlichen daran erkannt, dass sich der Strom durch die Solarmodule 5 ändert, da sich aufgrund fehlender Solarmodule 5 dessen Widerstand ändert. Dabei handelt es sich im Wesentlichen um eine sprunghafte Änderung, da sich bei Diebstahl eines oder mehrerer Solarmodule 5 aus dem Stromkreis auch der Widerstand im Wesentlichen sprunghaft ändert. Dieser Fall ist an Hand des Symboles eines Blitzes in Fig. 4 dargestellt. Dadurch ändert sich der durch das elektrische Signal hervorgerufene Strom entsprechend, wodurch aus einer Änderung des Stromes auf einen Diebstahl eines oder mehrerer Solarmodule 5 rückgeschlossen werden kann. Die Erkennung einer sprunghaften Änderung des empfangenen elektrischen Signals zur Erkennung des Diebstahls zumindest eines Solarmoduls 5 ist insbesondere bei der oben beschriebenen Variante, gemäß der der kapazitive Ableitstrom gemessen wird, von Bedeutung. Andere Einflussfaktoren, wie z.B. die Änderung der Luftfeuchtigkeit der Temperatur od. dgl., können nämlich nicht zu einer sprunghaften Änderung des Ableitstroms führen. Umgekehrt kann eine sprunghafte Änderung des gemessenen Stromes verlässlich auf die Entfernung eines Solarmoduls 5 rückgeschlossen werden. In der Regel werden gleich mehrere Solarmodule 5 entfernt werden, da bevorzugt mehrere Solarmodule 5 in Serie zu einem sogenannten Strang zusammengeschaltet sind. Wird nun zumindest ein Solarmodul 5 eines Stranges entfernt, wird somit der Widerstand der gesamten Energiequelle 13 durch Entfernen des Widerstands eines Stranges geändert.

Bei einer Erkennung eines Diebstahls durch die Umschaltvorrichtung 11 bzw. die Signaleinheit 19 kann ein Alarmsignal generiert werden, welches über den Datenbus 12 an eine Datenkommunikationseinheit 15 des Wechselrichters 1 übermittelt werden kann. Die Datenkommunikationseinheit 15 kann eine Warnmeldung, welche per Telefon, Fax, e-Mail od. dgl. an definierte Personen bzw. Einrichtungen übermittelt wird, erzeugen oder eine Warnleuchte, eine Signalhupe oder dgl. im Bereich der PV-Anlage bzw. in einer Zentrale aktvieren. Somit kann ein Diebstahl rasch erkannt und gegebenenfalls sogar verhindert werden.

Wird insbesondere während der Nachtstunden kein Diebstahl von Solarmodulen 5 erkannt, kann der Wechselrichter 1 wieder in den Normalbetrieb gemäß Fig. 2 umgeschaltet werden. Diese Umschaltung erfolgt wieder durch die Umschaltvorrichtung 11, welche die von den Solarmodulen 5 gelieferte Spannung überwacht. Überschreitet diese Spannung einen definierten bzw. einstellbaren Schwellwert, werden die Umschalter 16, 17 umgeschaltet, sodass die Anschlussleitungen 9, 10 mit dem Eingangs-DC-DC-Wandler 2 verbunden werden. Gleichzeitig wird ein entsprechendes Signal von der Steuereinheit 18 der Umschaltvorrichtung 11 an die Steuervorrichtung 8 des Wechselrichters 1 über den Datenbus 12 übermittelt, sodass bevorzugt die entsprechenden Hard- bzw. Softwarekomponenten aktiviert werden können. Somit kann der Wechselrichter 1 wieder Energie in das Versorgungsnetz 6 einspeisen bzw. die Verbraucher 7 versorgen.

Der Wechselrichter 1 wird während der Diebstahlerkennung vom Versorgungsnetz 6 oder einem Energiespeicher mit elektrischer Energie versorgt. Damit durch die dafür benötigte Energie der Wirkungsgrad des Wechselrichters 1 nicht wesentlich beeinflusst wird, kann das elektrische Signal auch in periodischen Zeitintervallen, beispielsweise im Sekundentakt, Zehnsekundentakt oder dgl., gesendet werden. Durch eine derartige energiesparende Maßnahme wird dennoch im Wesentlichen eine permanente Diebstahlerkennung erzielt.

Ebenso sei noch angemerkt, dass die erfindungsgemäße Diebstahlerkennung unabhängig vom Typ des Wechselrichters 1 ist. Anstelle des im Ausführungsbeispiel verwendeten HF-Wechselrichters 1 kann ebenso ein Wechselrichter 1 mit einem 50Hz-Trafo, ein transformatorloser Wechselrichter 1 oder ein Inselwechselrichter mit der Einrichtung zur Erkennung eines Diebstahls der Energiequelle 13 bzw. eines Solarmoduls 5 ausgestattet werden.

## Patentansprüche

1. Verfahren zur Erkennung des Diebstahls zumindest eines Solarmoduls (5) einer Photovoltaikanlage, wobei das zumindest eine Solarmodul (5) über Anschlussleitungen (9, 10) an zumindest einem Wechselrichter (1) angeschlossen wird und die Spannung des zumindest einen Solarmoduls (5) überwacht wird, und dass in einem Überwachungsbetrieb, wenn eine definierte Spannung des zumindest einen Solarmoduls (5) gemessen wird, ein elektrisches Signal erzeugt und zumindest an eine der Anschlussleitungen (9, 10) des zumindest einen Solarmoduls (5) angelegt wird, und das von dem zumindest einen Solarmodul (5) empfangene Signal gemessen und zur Beurteilung eines Diebstahls ausgewertet wird, **dadurch gekennzeichnet, dass** im Überwachungsbetrieb von einer Steuervorrichtung (8) eines Wechselrichters (1) eine Umschaltvorrichtung (11) aktiviert wird, und das zumindest eine Solarmodul (5) vom Wechselrichter (1) getrennt und mit einer Signaleinheit (19) verbunden wird, und zur Festlegung eines Referenzsignals für die Beurteilung eines Diebstahls des zumindest einen Solarmoduls (5) von der Signaleinheit (19) ein an den verwendeten Typ des zumindest einen Solarmoduls (5) angepasstes Signal generiert wird, indem aus in einem Speicher hinterlegten Daten für verschiedene Typen von Solarmodulen (5) hintereinander unterschiedliche elektrische Signale, welche sich in ihrer Signalform und Amplitude unterscheiden, generiert und zwischen den Anschlussleitungen (9, 10) oder zwischen einer der Anschlussleitungen (9, 10) und Erde angelegt und an das zumindest eine Solarmodul (5) gesendet werden, und jenes elektrische Signal automatisch als Referenzsignal für die Beurteilung eines Diebstahls ausgewählt wird, welches bei vorhandenem zumindest einen Solarmodul (5) in Abhängigkeit des jeweiligen Typs des zumindest einen Solarmoduls (5) ein verwertbares empfangenes Signal hervorruft, und dieses Referenzsignal gespeichert und eine Kalibrierung auf dieses Referenzsignal durchgeführt wird, das als Referenzsignal ausgewählte elektrische Signal in periodischen Zeitabständen ausgesendet wird, und bei Abweichung der Form des empfangenen Signals vom in Antwort auf das Referenzsignal empfangenen Signal ein Diebstahl des zumindest einen Solarmoduls (5) erkannt und ein Alarmsignal erzeugt wird.

2. Verfahren nach Anspruch 1, **dadurch gekennzeichnet, dass** das elektrische Signal von einer in der Umschaltvorrichtung (11) integrierten Signaleinheit (19) erzeugt wird.

3. Verfahren nach Anspruch 2, **dadurch gekennzeichnet, dass** zur Aktivierung der Umschaltvorrichtung (11) von der Steuervorrichtung (8) ein Startsignal an die Umschaltvorrichtung (11) übermittelt wird.

4. Verfahren nach Anspruch 3, **dadurch gekennzeichnet, dass** die Verbindung zumindest einer Anschlussleitung (9, 10) mit dem zumindest einen Wechselrichter (1) durch zumindest einen Umschalter (16, 17) unterbrochen wird und zumindest eine der Anschlussleitungen (9, 10) durch zumindest einen Umschalter (16, 17) mit der Signaleinheit (19) verbunden wird, wenn die Umschaltvorrichtung (11) aktiviert wird.

5. Verfahren nach einem der Ansprüche 1 bis 4, **dadurch gekennzeichnet, dass** als elektrisches Signal ein HF-Signal angelegt wird.

6. Verfahren nach einem der Ansprüche 1 bis 5, **dadurch gekennzeichnet, dass** ein Diebstahl aufgrund einer sprunghaften Änderung des empfangenen Signals erkannt wird.

7. Verfahren nach einem der Ansprüche 1 bis 6, **dadurch gekennzeichnet, dass** das Alarmsignal an eine Datenkommunikationseinheit (15) übermittelt wird.

8. Verfahren nach Anspruch 7, **dadurch gekennzeichnet, dass** über die Datenkommunikationseinheit (15) eine Nachricht an einen definierten Empfänger auf eine definierte Übertragungsmethode übermittelt wird.

9. Wechselrichter (1) mit einem DC-DC-Wandler (2), einem Zwischenkreis (3), einem DC-AC-Wandler (4), Anschlussleitungen (9, 10) zur Verbindung mit zumindest einem Solarmodul (5), einer Signaleinheit (19), einer Steuervorrichtung (8), einem Speicher und einer Steuereinheit (18) zur Messung der Spannung des zumindest einen Solarmoduls (5), wobei die mit den Anschlussleitungen (9, 10) verbindbare Signaleinheit (19) zur Erzeugung und Aussendung eines elektrischen Signals in einem Überwachungsbetrieb, und eine Einrichtung zum Messen und Auswerten des von dem zumindest einen Solarmodul (5) empfangenen Signals vorgesehen ist, sodass aus dem empfangenen Signal über den Diebstahl des zumindest einen Solarmoduls (5) rückschließbar ist, **dadurch gekennzeichnet, dass** eine Umschaltvorrichtung (11) zur Trennung des zumindest einen Solarmoduls (5) vom DC-DC-Wandler (2) und zur Verbindung des zumindest einen Solarmoduls (5) mit der Signaleinheit (19) im Überwachungsbetrieb vorgesehen ist, die Signaleinheit (19) mit der Steuervorrichtung (8) des Wechselrichters (1) und dem Speicher verbunden und zur Erzeugung eines für den verwendeten Typ des zumindest einen Solarmoduls (5) angepassten Signals ausgebildet ist, wobei die Signaleinheit (19) zur Generierung von unterschiedlichen elektrischen Signalen, welche sich in ihrer Signalform und Amplitude unterscheiden, aus den im Speicher hinterlegten Daten für verschiedene Typen von Solarmodulen (5) und zum Senden der unterschiedlichen elektrischen Signalen hintereinander an das zumindest eine Solarmodul (5) ausgebildet ist, dass die Signaleinheit (19) zur automatischen Festlegung und Speicherung eines Referenzsignals für die Beurteilung eines Diebstahls des zumindest einen Solarmoduls (5) als jenes elektrische Signal ausgebildet ist, welches bei vorhandenem zumindest einen Solarmodul (5) in Abhängigkeit des jeweiligen Typs des zumindest einen Solarmoduls (5) ein verwertbares empfangenes Signal hervorruft, dass die Signaleinheit (19) weiters zur Durchführung einer Kalibrierung auf dieses Referenzsignal, zur Aussendung des als Referenzsignal ausgewählten elektrischen Signals in periodischen Zeitabständen, und zur Erzeugung eines Alarmsignals bei Abweichung der Form des empfangenen Signals vom in Antwort auf das Referenzsignal empfangenen Signal als Zeichen für einen Diebstahl des zumindest einen Solarmoduls (5) ausgebildet ist.

10. Wechselrichter (1) nach Anspruch 9, **dadurch gekennzeichnet, dass** in der Umschaltvorrichtung (11) zumindest ein Umschalter (16, 17) angeordnet ist.

11. Wechselrichter (1) nach Anspruch 10, **dadurch gekennzeichnet, dass** zumindest einer der Umschalter (16, 17) zur Verbindung zumindest einer der Anschlussleitungen (9, 10) mit der Signaleinheit (19) bei aktivierter Umschaltvorrichtung (11) im Überwachungsbetrieb und zur Verbindung zumindest einer der Anschlussleitungen (9, 10) mit dem Wechselrichter (1) bei deaktivierter Umschaltvorrichtung (11) ausgebildet ist.

12. Wechselrichter (1) nach einem der Ansprüche 9 bis 11, **dadurch gekennzeichnet, dass** die Steuereinheit (18) über einen Datenbus (12) mit der Steuervorrichtung (8) verbunden ist.

13. Wechselrichter (1) nach Anspruch 11, **dadurch gekennzeichnet, dass** eine mit dem Datenbus (12) verbundene Datenkommunikationseinheit (15) zur Übermittlung einer Nachricht in Abhängigkeit eines erkannten Diebstahls des zumindest einen Solarmoduls (5) vorgesehen ist.

## Claims

1. A method for theft recognition of at least one solar module (5) on a photovoltaic unit, said at least one solar module (5) being connected via connector lines (9, 10) to at least one inverter (1), with the voltage of the at least one solar module (5) being monitored, and in a monitoring mode, when a defined voltage of the at least one solar module (5) is measured, an electric signal is generated and applied to at least one of the connector lines (9, 10) of the at least one solar module (5), and the signal received by the at least one solar module (5) is measured and analysed to assess a theft, **characterised in that** in monitoring mode a switchover device (11) is activated by a control device (8) of an inverter (1) and the at least one solar module (5) is disconnected from the inverter (1) and connected to a signal unit (19), and in order to set a reference signal for assessing a theft of the at least one solar module (5) a signal adjusted to fit the type of the at least one solar module (5) in use is generated by the signal unit (19) by generating from data for different types of solar modules (5), which is stored in a memory, in succession, different electric signals differing in form and amplitude, applying these signals between the connector lines (9, 10) or between one of the connector lines (9, 10) and earth and transmitting them to the at least one solar module (5), with that electric signal, which causes a useful received signal when at least one solar module (5) is present, depending on the respective type of the at least one solar module (5), being automatically selected as a reference signal for assessing a theft, and with this reference signal being stored and a calibration to this reference signal being performed, with the electric signal selected as the reference signal being transmitted in periodical intervals of time, and with a theft of at least one solar module (5) being detected and an alarm signal being generated when the form of the received signal differs from the signal received in response to the reference signal.

2. The method according to Claim 1, **characterised in that** the electric signal is generated by a signal unit (19) integrated in the switchover device (11).

3. The method according to Claim 2, **characterised in that** for activating the switchover device (11) a starting signal is transmitted from the control device (8) to the switchover device (11).

4. The method according to Claim 3, **characterised in that** the connection of at least one connector line (9, 10) to the at least one inverter (1) is interrupted by at least one switchover means (16, 17) and at least one of the connector lines (9, 10) is being connected to the signal unit (19) by at least one switchover means (16, 17) when the switchover device (11) is being activated.

5. The method according to any of the Claims 1 to 4, **characterised in that** as an electric signal a RF signal is being applied.

6. The method according to any of the Claims 1 to 5, **characterised in that** a theft is detected because of a sudden change in the received signal.

7. The method according to any of the Claims 1 to 6, **characterised in that** the alarm signal is transmitted to a data communication unit (15).

8. The method according to Claim 7, **characterised in that** via the data communication unit (15) a message is transmitted to a defined receiver by a defined method of transmission.

9. An inverter (1) with a DC-DC converter (2), an intermediate circuit (3), a DC-AC converter (4), connector lines (9, 10) for connecting to at least one solar module (5), a signal unit (19), a control device (8), a memory and a control unit (18) for measuring the voltage of the at least one solar module (5), providing the signal unit (19) which can be connected to the connector lines (9, 10) for generating and transmitting an electric signal in a monitoring mode, and a device for measuring and analysing the signal received by the at least one solar module (5), so conclusions can be drawn about the theft of the at least one solar module (5) from the received signal, **characterised in that** a switchover device (11) is provided for disconnecting the at least one solar module (5) from the DC-DC converter (2) and for connecting the at least one solar module (5) to the signal unit (19) in monitoring mode, and the signal unit (19) is connected to the control device (8) of the inverter (1) and the memory and designed to generate a signal adjusted to fit the type of the at least one solar module (5) in use, wherein the signal unit (19) is designed to generate from data for different types of solar modules (5), which is stored in the memory, different electric signals that differ in form and amplitude and to transmit, in succession, the different electric signals to the at least one solar module (5), and **in that** the signal unit (19) is designed to automatically set and store as a reference signal for assessing a theft of the at least one solar module (5) that electric signal, which causes a useful received signal when at least one solar module (5) is present, depending on the respective type of solar module (5), and **in that** the signal unit is further designed to perform a calibration to this reference signal, to transmit the electric signal selected as the reference signal in periodical intervals of time, and to generate an alarm signal as an indicator for a theft of the at least one solar module (5) when the form of the received signal differs from the signal received in response to the reference signal.

10. The inverter (1) according to Claim 9, **characterised in that** at least one switchover means (16, 17) is arranged within the switchover device (11).

11. The inverter (1) according to Claim 10, **characterised in that** at least one of the switchover means (16, 17) is designed for connecting at least one of the connector lines (9, 10) to the signal unit (19) when the switchover device (11) is activated in monitoring mode and for connecting at least one of the connector lines (9, 10) to the inverter (1) when the switchover device (11) is deactivated.

12. The inverter (1) according to any of the Claims 9 to 11, **characterised in that** the control unit (18) is connected to the control device (8) via a data bus (12).

13. The inverter (1) according to Claim 11, **characterised in that** a data communication unit (15), which is connected to the data bus (12), is provided for transmitting a message depending on a detected theft of the at least one solar module (5).

## Revendications

1. Procédé de détection du vol d'au moins un module solaire (5) d'une installation photovoltaïque, l'au moins un module solaire (5) étant raccordé via des lignes de raccordement (9, 10) à au moins un onduleur (1) et la tension de l'au moins un module solaire (5) étant surveillée, et que, pendant une phase de surveillance, lorsqu'une tension définie de l'au moins un module solaire (5) est mesurée, un signal électrique est généré et est appliqué à au moins une des lignes de raccordement (9, 10) de l'au moins un module solaire (5), et le signal reçu de l'au moins un module solaire (5) est mesuré et est analysé pour constater un vol, **caractérisé en ce que** dans la phase de surveillance, un dispositif de commutation (11) est activé par un dispositif de commande (8) d'un onduleur (1), et l'au moins un module solaire (5) est séparé de l'onduleur (1) et est relié à une unité de signaux (19), et, pour définir un signal de référence destiné à la constatation d'un vol de l'au moins un module solaire (5), l'unité de signaux (19) génère un signal ajusté au type utilisé de l'au moins un module solaire (5), en générant les uns après les autres, à partir de données, enregistrées dans une mémoire, pour différents types de modules solaires (5), des signaux électriques différents, qui se distinguent par leur forme et leur amplitude, et en les appliquant entre les lignes de raccordement (9, 10) ou entre l'une des lignes de raccordement (9, 10) et la terre et en les envoyant à l'au moins un module solaire (5), et ce signal électrique qui, en présence d'au moins un module solaire (5), génère en fonction du type correspondant de l'au moins un module solaire (5) un signal reçu exploitable, est choisi automatiquement comme signal de référence pour la constatation d'un vol, et ce signal de référence est mémorisé et un calibrage est effectué sur ce signal de référence, le signal électrique choisi comme signal de référence est émis dans des intervalles de temps périodiques, et un vol de l'au moins un module solaire (5) est détecté lorsque la forme du signal reçu diffère du signal reçu en réponse au signal de référence, et un signal d'alarme est généré.

2. Procédé selon la revendication 1, **caractérisé en ce que** le signal électrique est généré par une unité de signaux (19) intégrée dans le dispositif de commutation (11).

3. Procédé selon la revendication 2, **caractérisé en ce qu'**un signal de départ est transmis au dispositif de commutation (11) pour que le dispositif de commande (8) active le dispositif de commutation (11).

4. Procédé selon la revendication 3, **caractérisé en ce que** la liaison d'au moins une ligne de raccordement (9, 10) doté de l'au moins un onduleur (1) est interrompue par au moins un commutateur (16, 17) et au moins une des lignes de raccordement (9, 10) est reliée, par l'intermédiaire d'au moins un commutateur (16, 17), à l'unité de signaux (19) lorsque le dispositif de commutation (11) est activé.

5. Procédé selon l'une quelconque des revendications 1 à 4, **caractérisé en ce qu'**un signal HF est appliqué comme signal électrique.

6. Procédé selon l'une quelconque des revendications 1 à 5, **caractérisé en ce qu'**un vol est détecté en raison d'une brusque variation du signal reçu.

7. Procédé selon l'une quelconque des revendications 1 à 6, **caractérisé en ce que** le signal d'alarme est transmis à une unité de communication des données (15).

8. Procédé selon la revendication 7, **caractérisé en ce qu'**une information est transmise, par l'intermédiaire de l'unité de communication des données (15), à un récepteur défini selon une méthode de transmission définie.

9. Onduleur (1) doté d'un convertisseur courant continu-courant continu (2), d'un circuit intermédiaire (3), d'un convertisseur courant continu-courant alternatif (4), de lignes de raccordement (9, 10) pour le raccordement à au moins un module solaire (5), une unité de signaux (19), un dispositif de commande (8), une mémoire et une unité de commande (18) pour mesurer la tension de l'au moins un module solaire (5), l'unité de signaux (19), pouvant être reliée aux lignes de raccordement (9, 10), étant prévue pour générer et émettre un signal électrique pendant une phase de surveillance et un dispositif étant prévu pour mesurer et analyser le signal reçu de l'au moins un module solaire (5), de sorte qu'à partir du signal reçu, il est possible de déduire le vol de l'au moins un module solaire (5), **caractérisé en ce qu'**un dispositif de commutation (11) est prévu pour séparer l'au moins un module solaire (5) du convertisseur courant continu-courant continu (2) et pour relier l'au moins un module solaire (5) à l'unité de signaux (19) pendant la phase de surveillance, l'unité de signaux (19) est reliée au dispositif de commande (8) de l'onduleur (1) et à la mémoire et est configurée pour générer un signal ajusté au type utilisé de l'au moins un module solaire (5), l'unité de signaux (19) étant configurée pour générer des signaux électriques différents, qui se distinguent par leur forme et leur amplitude, à partir des données, enregistrées dans la mémoire, pour différents types de modules solaires (5) et pour émettre les signaux électriques différents les uns après les autres à l'au moins un module solaire (5), **en ce que** l'unité de signaux (19) est configurée pour une définition et une mémorisation automatiques d'un signal de référence pour la constatation d'un vol de l'au moins un module solaire (5), sous la forme de ce signal électrique qui, en présence d'au moins un module solaire (5), génère en fonction du type correspondant de l'au moins un module solaire (5) un signal reçu exploitable, **en ce que** l'unité de signaux (19) est également configurée pour effectuer un calibrage sur ce signal de référence, pour émettre dans des intervalles de temps périodiques le signal électrique choisi comme signal de référence, et pour générer un signal d'alarme lorsque la forme du signal reçu diffère du signal reçu en réponse au signal de référence, ce qui indique un vol de l'au moins un module solaire (5).

10. Onduleur (1) selon la revendication 9, **caractérisé en ce qu'**au moins un commutateur (16, 17) est disposé dans le dispositif de commutation (11).

11. Onduleur (1) selon la revendication 10, **caractérisé en ce qu'**au moins un des commutateurs (16, 17) est configuré pour relier au moins une des lignes de raccordement (9, 10) à l'unité de signaux (19) lorsque le dispositif de commutation (11) est activé pendant la phase de surveillance et pour relier au moins une des lignes de raccordement (9, 10) à l'onduleur (1) lorsque le dispositif de commutation (11) est désactivé.

12. Onduleur (1) selon l'une quelconque des revendications 9 à 11, **caractérisé en ce que** l'unité de commande (18) est reliée au dispositif de commande (8) via un bus de données (12).

13. Onduleur (1) selon la revendication 11, **caractérisé en ce qu'**une unité de communication des données (15), reliée au bus de données (12), est prévue pour transmettre une information en fonction d'un vol détecté de l'au moins un module solaire (5).
